# FASCICULE DE BREVET EUROPEEN

(11) **EP 2 263 251 B1**
(45) Date de publication et mention de la délivrance du brevet: **18.01.2012**
(21) Numéro de dépôt: 09731294.6
(22) Date de dépôt: 03.04.2009
(51) Int. Cl.: H01L 21/18

(54) **PROCEDE DE TRANSFERT A L'AIDE D'UN SUBSTRAT FERROELECTRIQUE**
VERFAHREN ZUR ÜBERTRAGUNG MIT EINEM FERROELEKTRISCHEN SUBSTRAT
METHOD OF TRANSFER USING A FERROELECTRIC SUBSTRATE

(30) Priorité: 07.04.2008 FR 0852302
(43) Date de publication de la demande: 22.12.2010
(73) Titulaire: Commissariat à l'Énergie Atomique et aux Énergies Alternatives, 75015 Paris (FR)
(72) Inventeur: MOULET, Jean-Sébastien, F-73000 Chambery (FR); DI CIOCCIO, Léa, F-38330 Saint Ismier (FR); MIGETTE, Marion, F-38000 Grenoble (FR)
(74) Mandataire: Ilgart, Jean-Christophe
(86) Numéro de dépôt international: PCT/EP2009/054007
(87) Numéro de publication internationale: WO 2009/124886

(56) Documents cités:
- EP-A- 0 621 130
- EP-A- 1 777 735
- US-A1- 2003 010 275

## Description

### DOMAINE TECHNIQUE ET ART ANTÉRIEUR

L'invention concerne les techniques de transfert de substrat, que l'on utilise en particulier en micro-électronique.

Dans ce domaine, on cherche souvent à utiliser un support temporaire, également appelé « poignée ». Sur un tel support peuvent être temporairement fixés un ou plusieurs composants, qui peuvent ensuite être encore reportés sur un autre support, définitif. Le support ou le substrat poignée peut alors être réutilisé pour un autre transfert.

Il se pose souvent le problème de pouvoir détacher de manière simple le ou les composants qui ont été fixés temporairement sur le substrat poignée.

En outre, les composants tendent à être de plus en plus petits, et les techniques de report connues, et donc les substrats utilisés couramment comme poignées, ne sont pas toujours adaptés à des dimensions constamment décroissantes. Le document US2003/010275 (publié le 16 Janvier 2003) décrit un procédé de fabrication de retardateur d'onde à base d'oxyde métallique monocristallin (LiNbO3) et l'utilisation de ces retardateurs pour les guides d'ondes optiques.

### EXPOSÉ DE L'INVENTION

L'invention concerne un procédé de réalisation d'un transfert d'un ou plusieurs premiers composants ou d'une première couche, sur un premier substrat vers un deuxième substrat, comportant les étapes suivantes :
a) la mise en contact, contre le premier substrat, en un matériau ferroélectrique, du ou des premiers composants ou de la première couche, et leur maintien par effet électrostatique contre ce premier substrat,
b) une mise en contact par adhérence moléculaire, de ces premiers composants ou de cette première couche avec le deuxième substrat,
c) une séparation ou un démontage du premier substrat, laissant au moins une partie de chacun desdits composants ou de ladite couche sur le deuxième substrat.

L'étape a) met en oeuvre le champ interne du substrat en matériau ferroélectrique, qui est chargé de manière intrinsèque.

De ce fait, il n'y a pas de fuites de charges et la polarisation peut être maintenue en l'état tant qu'il n'y a pas de décharges par une intervention extérieure. Il n'y a donc pas de limite de temps à l'utilisation de l'assemblage entre le premier substrat et les composants ou la première couche.

Le démontage du premier substrat peut être assisté :
- thermiquement, en particulier par effet de la différence de dilatation thermique entre le premier et le deuxième substrat, ou par application d'une rampe thermique rapide (supérieure ou égale à 5°C/min) qui introduit un effet de décharge par accumulation de charges. Une montée en température permet en outre de renforcer le contact direct,
- et/ou mécaniquement, en particulier par un effet de courbure du deuxième substrat, qui induit un décollement du premier substrat 1, le collage des composants étant plus fort à l'interface avec le deuxième substrat. Le contact direct du ou des composants sur le deuxième substrat va permettre de les retenir sur celui-ci lorsque le premier substrat va être éloigné,
- et/ou de manière électrostatique, en particulier par renversement de la polarisation par chauffage ou par une polarisation inverse.

Avantageusement, le matériau ferroélectrique du premier substrat est du LTO (LiTaO₃) ou un matériau de même structure que le LTO, tel que LiNbO₃, BaTiO₃, ou SrTiO₃, ou le LaAlO₃, ou le LiAlO₃, ou tout autre matériau ferroélectrique.

Avantageusement, on peut réaliser sur la surface du deuxième substrat une préparation en vue d'un collage moléculaire, les composants ou la couche étant ensuite mis en contact avec cette surface préparée et assemblés avec elle par collage moléculaire.

Un ou plusieurs desdits composants, ou ladite couche, peut avoir subi, avant l'étape a), ou subir, entre l'étape a) et l'étape b), un traitement par gravure, et/ou implantation ionique, et/ou dépôt et/ou thermique.

Dans le cas d'un traitement par implantation ionique avant l'étape a), ou entre l'étape a) et l'étape b), une zone de fragilisation est réalisée dans au moins un desdits composants ou de ladite couche, le long de laquelle une fracture est réalisée lors de l'étape c).

Dans le cas d'un traitement par implantation ionique avant l'étape a), une zone de fragilisation est réalisée dans au moins un desdits composants ou de ladite couche, le long de laquelle une fracture est réalisée entre l'étape a) et l'étape b).

Suivant la profondeur de l'implantation et la face des composants ou de la couche traversée par l'implantation, la couche reportée lors de l'étape c) peut être plus ou mois épaisse.

On peut déposer une couche sur la surface du matériau ferroélectrique, pour favoriser le collage, par exemple une couche d'oxyde de silicium SiO2 ou un polymère (PDMS, BCB) à tenue faible ou très faible.

L'opération de report peut être réalisée à plusieurs reprises, en particulier à l'aide du même premier substrat ferroélectrique, une couche étant ainsi reportée, ou des composants étant ainsi reportés, sur une couche déjà reportée, ou sur des composants déjà reportés, ce qui permet de réaliser des empilements ou des étages de composants sur un même deuxième substrat.

Ainsi l'invention a aussi pour objet un procédé de réalisation d'un transfert d'au moins deux étages de composants et/ou de couche sur un deuxième substrat, comportant les étapes suivantes :
- réalisation d'un transfert d'un premier étage d'un ou plusieurs premiers composants ou d'une première couche sur ledit deuxième substrat, selon l'invention exposée ci-dessus, à l'aide d'un premier substrat, en un matériau ferroélectrique,
- puis la réalisation d'un transfert d'un deuxième étage d'un ou plusieurs deuxièmes composants ou d'une deuxième couche, sur ledit premier étage.

Le transfert d'un deuxième étage peut être réalisé par :
a') l'application et le maintien, par effet électrostatique, desdits un ou plusieurs deuxièmes composants ou de ladite deuxième couche, sur ledit premier étage, à l'aide d'un substrat, en un matériau ferroélectrique, électriquement chargé,
b') une mise en contact et un report de ces composants ou de cette couche sur ledit premier étage,
c') un démontage dudit substrat en un matériau ferroélectrique, laissant le ou les composants ou ladite deuxième couche sur le premier étage.

Le transfert du premier étage peut être réalisé avec le même substrat, en un matériau ferroélectrique, que le transfert du deuxième étage.

Au moins le premier substrat peut comporter des marques d'alignement.

Quel que soit le mode de réalisation, un procédé selon l'invention permet un nouveau mode de manipulation d'un film ou de vignettes, en ayant un support temporaire, par collage électrostatique.

### BRÈVE DESCRIPTION DES DESSINS

- Les figures 1A-1D représentent un premier mode de réalisation de l'invention,
- les figures 2A-2B représentent un deuxième mode de réalisation de l'invention, avec transfert de deux étages,
- les figures 3A-3D représentent un procédé selon l'invention, avec transfert d'une couche,
- les figures 4A-4D représentent un autre procédé de transfert d'une portion d'une couche, selon l'invention, comportant une étape d'implantation et une étape de fracture de ladite couche,
- les figures 5A-5C représentent encore un autre procédé de transfert d'une portion d'une couche, selon l'invention, comportant une étape d'implantation et une étape de fracture de ladite couche,
- les figures 6A-6C représentent un autre procédé de transfert de parties de vignettes, selon l'invention, comportant une étape d'implantation et une étape de fracture desdites vignettes,
- les figures 7A-7C représentent encore un autre procédé de transfert de parties de vignettes selon l'invention, comportant une étape d'implantation et une étape de fracture desdites vignettes.

### EXPOSÉ DÉTAILLÉ DE MODES DE RÉALISATION PARTICULIERS

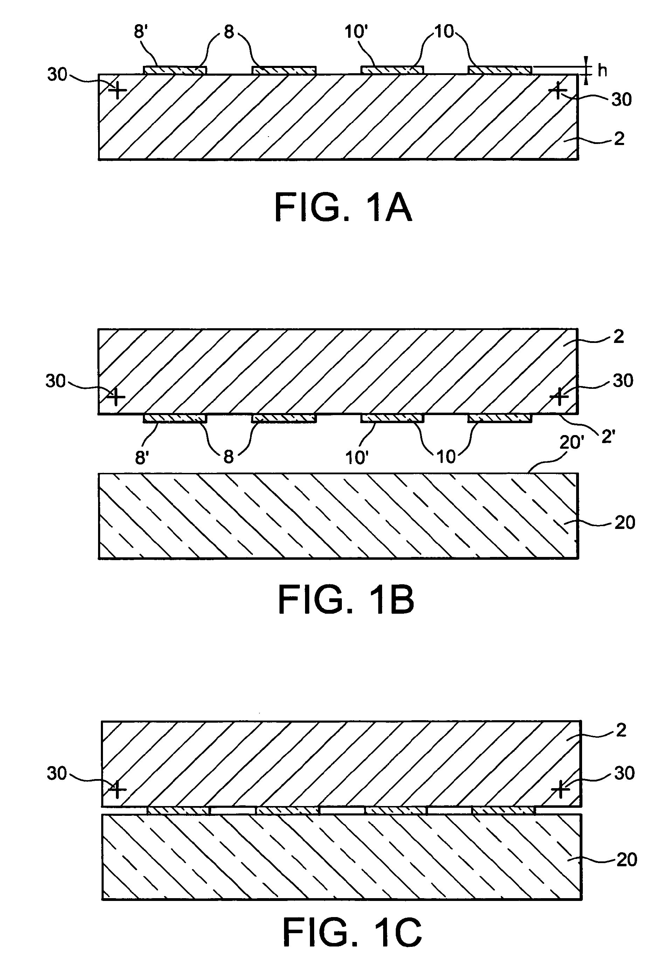

Un premier exemple de procédé selon l'invention va être donné en liaison avec les figures 1A-1C, en partant d'un premier substrat 2, massif ou en couche mince, en un matériau ferroélectrique, par exemple en LiTaO₃. Ce type de matériau, de même que les autres matériaux ferroélectriques utilisables cités ci-dessus, ont une polarisation intrinsèque qui va pouvoir être exploitée dans le cadre de la présente invention.

Des composants 8, 10, par exemple du type « vignette » (on utilise dans la suite, indifféremment, le terme composant ou vignette) sont déposés sur ce substrat 2 (figure 1A). Ces composants sont par exemple des substrats de matériaux semi-conducteurs, comportant, ou non, des circuits. Ils sont principalement à base de silicium ou de germanium ou d'AsGa ou d'InP ou en d'autres matériaux.

La référence 30 désigne d'éventuelles marques d'alignement sur le substrat 2, qui permettront de réaliser ultérieurement un bon alignement sur un deuxième substrat 20, ou substrat de report, notamment si des marques d'alignement sont également prévues sur le deuxième substrat 20.

Ces composants 8, 10 peuvent être de toutes tailles, ce sont par exemple des puces. Chaque côté de l'un de ces composants peut mesurer entre quelques micromètres et plusieurs millimètres ou plusieurs centimètres, par exemple entre 1 µm ou 5 µm et 1 mm ou 5 mm ou 5 cm.

Les dimensions, et en particulier l'épaisseur de chaque composant, peuvent être telles qu'il ne puisse être manipulé individuellement. En particulier, son épaisseur peut être de l'ordre de quelques nanomètres à quelques dizaines de nanomètres, par exemple comprise entre 5 nm ou 10 nm et 50 nm. C'est le cas, notamment, de certaines vignettes ou de certaines puces. Une technique de report selon l'invention rend cette vignette ou cette puce manipulable.

L'épaisseur des composants peut aussi être plus importante, par exemple de 750µm ou plus, ou même de plusieurs millimètres.

Les surfaces 8', 10' (figure 1A) des divers composants peuvent être disposées sensiblement à la même hauteur h par rapport à la surface 2' du premier substrat 2 sur laquelle ces composants sont déposés.

En variante ces surfaces 8' et 10' peuvent ne pas être à la même hauteur h par rapport à cette même surface 2' du substrat 2. C'est le cas notamment si au moins l'un des composants comporte au moins une surface en un matériau présentant une élasticité ou compliant, par exemple un polymère. Il a été montré par Jourdain et al. « BCB Collective Hybrid Bonding for 3D-Stacking » Conference on Wafer Bonding for MEMS Technologies and Wafer Level Integration, 2007 qu'une couche compliante polymère, par exemple en BCB, peut accepter lors de reports des différences de hauteur de plus de 3 mm.

Préalablement au dépôt, les composants 8, 10 peuvent avoir subi une étape de traitement en vue de favoriser le contact ou l'adhésion avec la surface 2' du premier substrat 2, par exemple un traitement par polissage ou par activation plasma. Ce type de traitement peut faire apparaître, à l'interface entre les vignettes et la surface 2' du substrat 2 quelques monocouches d'eau.

Avantageusement, on pourra réaliser le même type de préparation sur la surface 20' du deuxième substrat 20, en vue d'un collage moléculaire. Mais ce collage 20-20' peut aussi être fait à l'aide de colle.

L'adhésion électrostatique de chaque composant ou vignette 8, 10 sur le premier substrat 2 est obtenue par les charges électriques naturelles de ce substrat 2. La polarisation spontanée de ce dernier peut être renforcée par l'application d'un champ électrique.

Une fois maintenus sur le substrat 2, les composants 8, 10 peuvent subir un ou des traitements, par exemple une gravure, et/ou une implantation ionique, et/ou un dépôt, etc... ; dans le cas d'étapes avec élévation de température, la ou les rampes sont choisies, lors du budget thermique, de manière à ne pas avoir de phénomène d'inversion de polarisation du premier substrat (ferroélectrique); typiquement on utilise une ou des rampe(s) inférieure(s) à 5°C/minute. En outre on limite la température à une valeur inférieure à la température de Curie Tc du matériau ferroélectrique (pour du Tantalate, cette température de Curie est égale à environ 600°C ; pour le Niobate elle est d'environ 1200°C).

En variante, les composants 8, 10 peuvent être préparés en vue d'un collage direct ou moléculaire avec la surface 20' du deuxième substrat 20 de report, éventuellement après, ou en combinaison avec, un ou plusieurs des traitements précédents.

L'ensemble obtenu peut donc également, comme illustré sur la figure 1B, être ensuite positionné en face d'un tel substrat 20 de report, sur lequel les composants ou les vignettes vont être transférées. La ou les marques 30 d'alignement peuvent aider au positionnement relatif des deux substrats 2, 20.

Le substrat de report 20 est par exemple en silicium ou en un autre matériau semi-conducteur, ou tout autre matériau comme de la silice fondue ou du quartz.

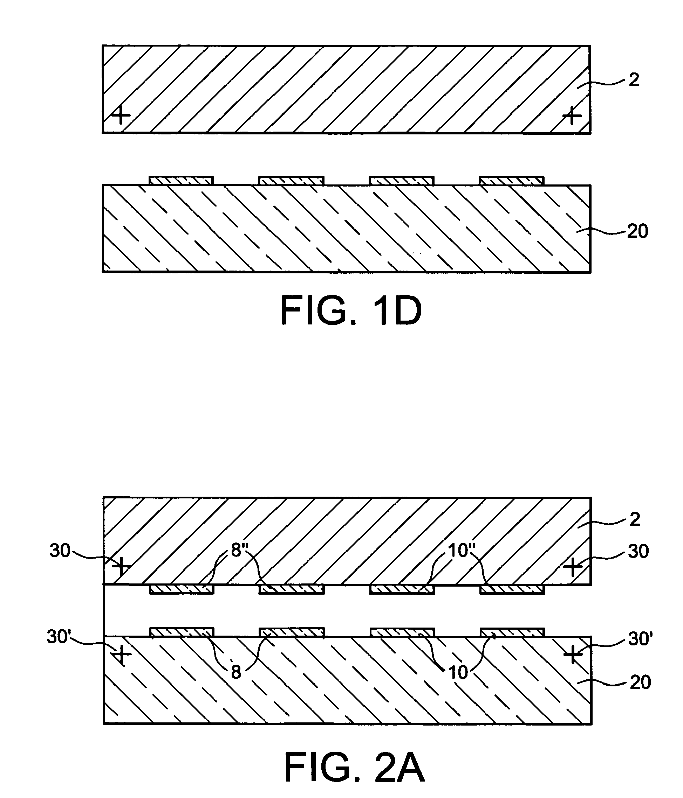

Il est procédé à la mise en contact de la surface 8', 10' des composants ou des vignettes 8, 10 et de la surface 20' du deuxième substrat 20 (figure 1C). L'adhésion des vignettes sur ce dernier est de type collage moléculaire, ce qui permet de les maintenir sur le support ou le deuxième substrat 20, de manière plus ferme qu'ils ne le sont, par effet électrostatique, sur le premier substrat 2. Ce dernier peut donc être enlevé (figure 1D), les composants étant reportés sur le substrat 20. On a donc un décollement, ou une séparation, du substrat 2 par effet mécanique, ou du fait de la différence de force d'adhérence entre l'adhésion des composants ou des vignettes 8, 10 sur le substrat ferroélectrique 2 et leur adhésion sur le substrat 20, cette dernière étant plus grande. Ceci peut en outre entraîner une différence de courbure entre les deux substrats, qui induit, ou favorise, le décollement. Toutes ces étapes sont de préférence réalisées à température ambiante, comprise entre 20°C et 30°C par exemple, sauf les traitements de type implantation et/ou dépôt.

En variante, le décollement peut être obtenu par effet thermique, ou bien un effet thermique peut assister l'effet mécanique pour décoller les vignettes du substrat 2.

Plus précisément, une étape de chauffage permet de réaliser la séparation des composants 8, 10 du substrat 2. Ce chauffage (à température de plusieurs centaines de °C, par exemple comprise entre 100°C ou 500°C et 1200°C, pendant une durée comprise entre quelques minutes et plusieurs heures, par exemple comprise entre 1h ou 4h et 10h ou même 30h) permet également de renforcer l'adhésion directe ou moléculaire des composants 8, 10 sur le deuxième substrat 20, par rapport à l'adhésion sur le substrat 2.

Sous l'effet de la température, des différences entre les coefficients de dilatation thermique des matériaux des substrats 2 et 20 et/ou entre les coefficients de dilatation thermique des matériaux du substrat ou des substrats 2 et/ou 20 et les vignettes 8, 10 peuvent également favoriser un décollement du premier substrat. C'est notamment le cas si le coefficient de dilatation thermique du matériau du premier substrat est supérieur à celui des vignettes 8, 10. Cette condition est vérifiée pour le LTO (de même que pour les autres matériaux ferroélectriques déjà envisagés pour le substrat 2) qui se dilate en général plus que les vignettes (principalement en matériau semi-conducteur). Ces dernières ne bougent donc pas ou peu.

Lors de l'étape de décollement, une rampe thermique croissante peut être appliquée. En particulier, sous l'effet d'une rampe thermique supérieure à 5°C/min, une accumulation de charges dans le matériau du substrat 2 permet une décharge de ce dernier et permet ou favorise donc le décollement.

On réalise donc un décollement du substrat 2 par effet thermique ou par combinaison d'effets mécanique et thermique ou électrique et thermique.

Un autre mode de réalisation de l'invention va être expliqué en partant d'un deuxième substrat 20, identique ou similaire à celui de la figure 1D, donc auquel une pluralité de vignettes 8, 10, formant un premier étage, adhère déjà. Des composants 8", 10" , par exemple du même type que ceux mentionnés ci-dessus, vont être déposés sur ce premier étage.

Par la même technique de report que celle déjà décrite à l'aide du substrat ferromagnétique 2, le deuxième étage de composants 8" , 10".... peut être déposé sur le premier étage de composants 8, 10. La liaison entre 8 et 8", 10 et 10" peut être de même nature que la liaison antérieure entre substrat 20 et composants 8, 10, elle peut être aussi réalisée à l'aide de colle. Ce transfert d'un deuxième étage peut être réalisé à l'aide du même substrat 2 ferroélectrique que le transfert du premier étage.

Là encore, un marquage adéquat réalisée par exemple à la fois sur le substrat 2 et le substrat 20, permet de réaliser un bon alignement et une bonne superposition des composants les uns sur les autres. Des marques 30, 30' sont identifiées dans les substrats 2, 20 de la figure 2A.

Cette variante de l'invention permet de réaliser des empilements ou des étages de composants sur le deuxième substrat 20.

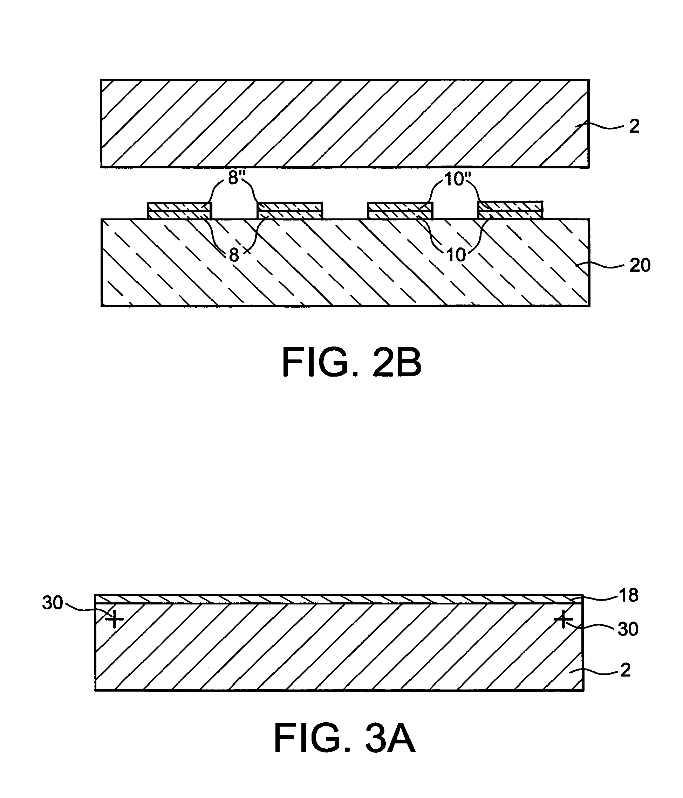

Sur la figure 2B un composant ou une vignette 8" , 10" est indiqué en superposition de chaque composant ou vignette 8, 10, mais ce n'est pas obligatoire, la répartition des composants ou vignettes 8", 10" sur le premier étage peut être différente. Sur cette figure, le substrat 2 est représenté, comme expliqué ci-dessus, après avoir été décollé ou séparé par les composants 8" , 10" par effet thermique ou par combinaison d'effets mécanique et thermique ou électrique et thermique.

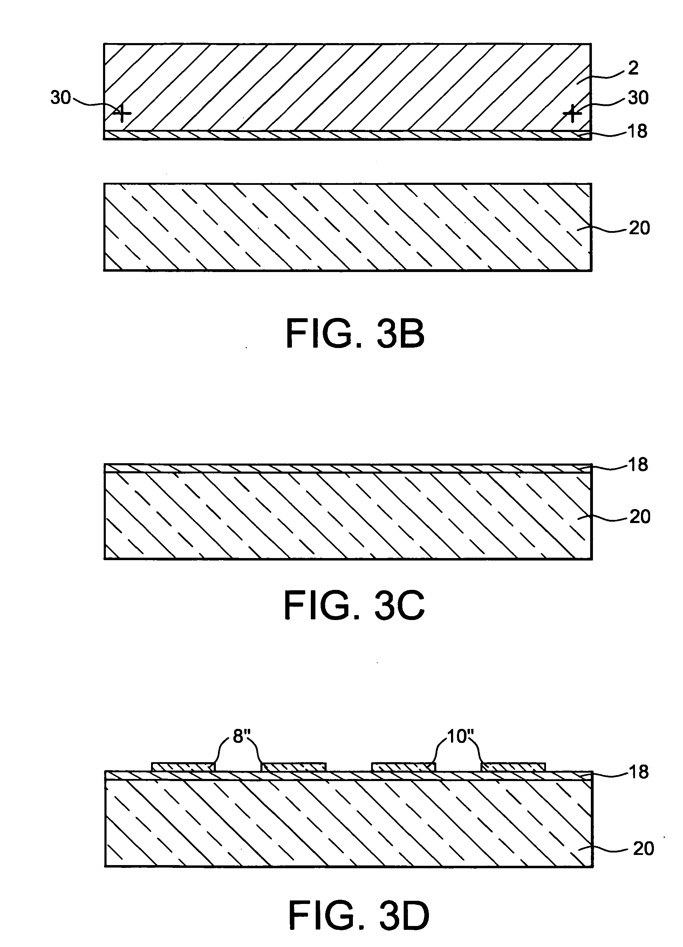

Ce qui a été décrit pour des composants ou vignettes individuelles s'applique à une couche unique : comme illustré sur les figures 3A-3C, il est possible de maintenir une couche 18 complète, par exemple en au moins un des matériaux semi-conducteurs déjà cités, sur le substrat 2 ferroélectrique (éventuellement muni, là encore, de marques d'alignement 30). Puis, on procède à un report sur le substrat 20 (figures 3B et 3C), avec assistance d'un ou plusieurs des effets déjà mentionnés (mécanique, et/ou thermique, et/ou électrostatique). On a ainsi formé le premier étage.

Un deuxième étage peut être reporté sur la couche 18 de la figure 3C, ce peut être un étage de composants ou de vignettes 8" , 10" ou un étage comportant une deuxième couche. La figure 3D représente le résultat d'un double report, d'abord celui d'une couche 18, puis, sur cette couche, de composants 8" , 10" .

Ce transfert d'un deuxième étage peut être réalisé à l'aide du même substrat 2 ferroélectrique que le transfert du premier étage, et selon l'un des procédés décrits ci-dessus.

Un autre mode de réalisation met en oeuvre un procédé de fracture de substrat, tel que le procédé « Smart Cut™ », par exemple décrit dans l'article de B. Aspar et A.J. Auberton - Hervé « Silicon Wafer Bonding Technology for VLSI and MEMS applications », edited by S.S. Iyer and A.J. Auberton - Hervé, 2002, INSPEC, London, Chapter 3, pages 35-52, ou encore dans les documents déjà cités ci-dessus.

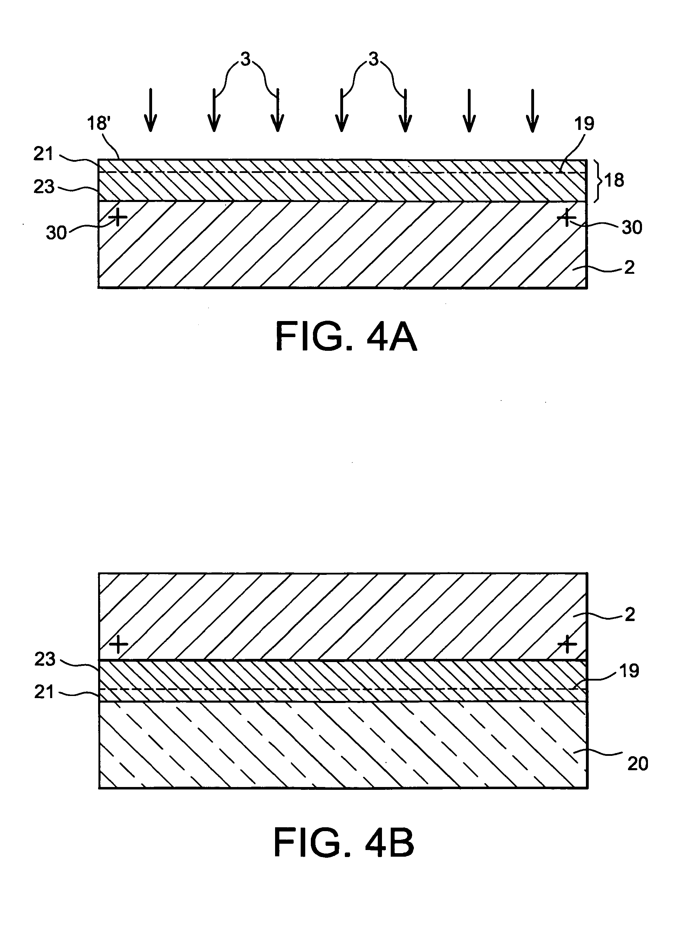

Les figures 4A à 4D illustrent un exemple de mise en oeuvre d'un tel procédé de fabrication ou de transfert de couche mince. Ces figures sont des vues en coupe transversale.

La figure 4A montre le substrat ferroélectrique de la figure 3A, avec sa couche 18 telle que décrite ci-dessus, mais de manière agrandie sur la figure 4A, subissant une étape d'implantation d'une espèce gazeuse, symbolisée par les flèches 3. Pour une couche 18 en silicium, on peut par exemple implanter de l'hydrogène à une énergie de 200 keV et une dose de l'ordre de 6.10¹⁵ H⁺/cm². Il se forme alors une zone enterrée 19 constituant une zone fragilisée, qui délimite deux parties dans la couche 18 :
- une couche mince 21, d'épaisseur comprise entre quelques nm et quelques centaines de micromètres, par exemple comprise entre 10 nm et 200 µm, située entre la face 18', à travers laquelle l'implantation a eu lieu, et la zone fragilisée 19,
- et la partie restante 23 de la couche 18, située entre la zone fragilisée 19 et le substrat 20.

Il est ensuite procédé à un assemblage de la couche 18 implantée, par sa face 18' à travers laquelle l'implantation a été réalisée, avec le substrat 20 de report (figure 4B).

Pour ces opérations les techniques utilisées sont celles déjà décrites ci-dessus.

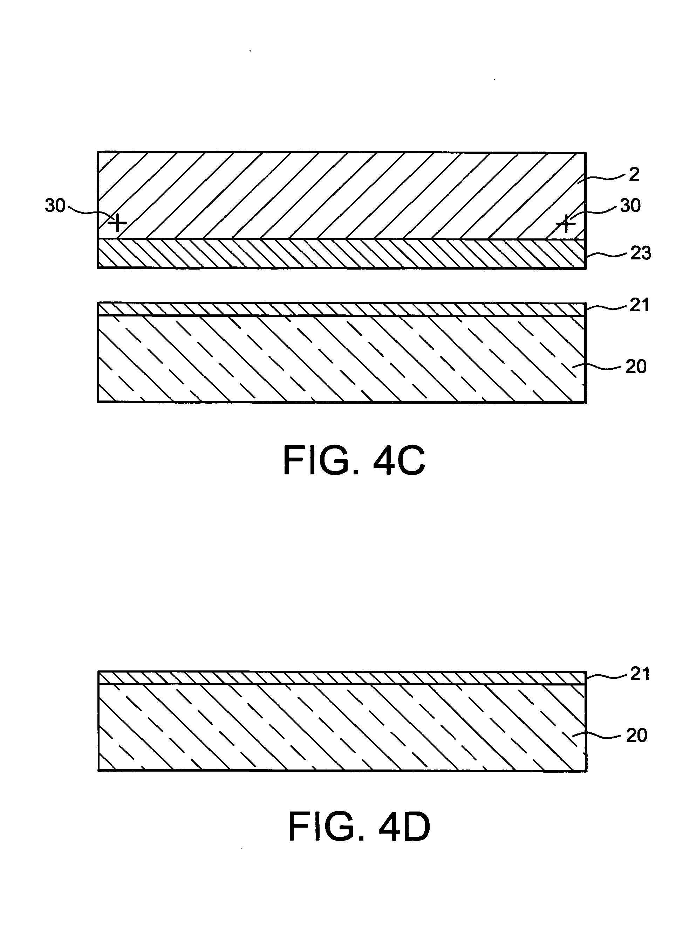

La figure 4C illustre une étape de séparation, induite par effet thermique et/ou mécanique, de la couche mince 21 et de la partie restante 23 de la couche 18, le long de la zone fragilisée 19. Il reste la structure de la figure 4D, à savoir la couche mince 21 sur le substrat 20 de report.

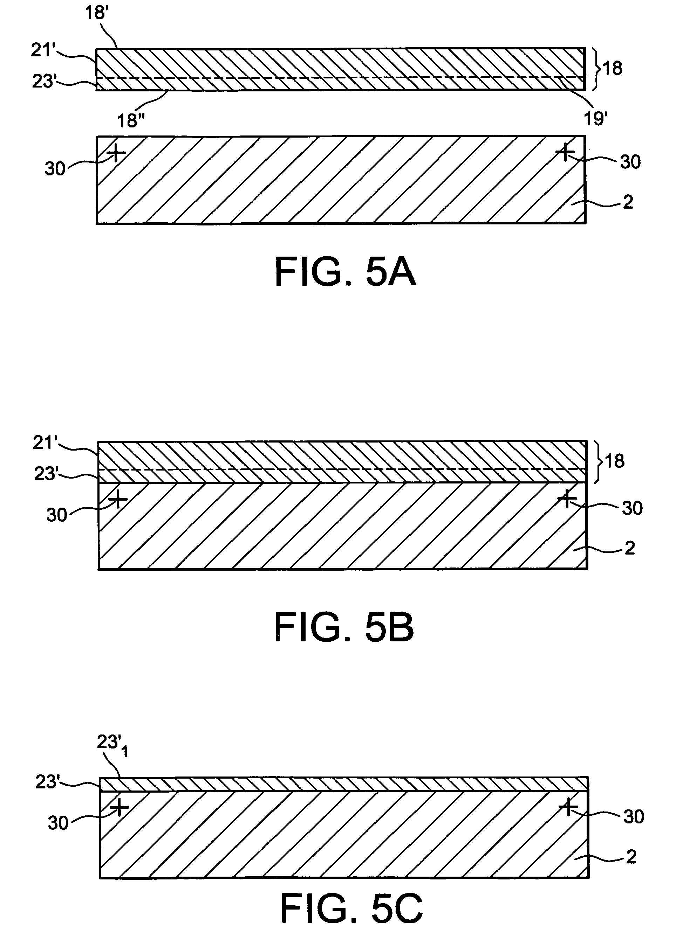

En variante (figures 5A à 5C), on procède d'abord à une implantation dans une couche (ou un substrat) 18. Dans le cas du silicium, on se reportera aux valeurs d'implantation données ci-dessus.

On obtient donc une zone enterrée 19' constituant une zone fragilisée, qui sépare la couche 18 en deux parties :
- une couche mince 23', d'épaisseur comprise entre quelques nm et quelques centaines de micromètres, par exemple comprise entre 10 nm et 200 µm, située entre la face 18" à travers laquelle l'implantation a eu lieu et la zone fragilisée 19',
- et la partie restante 21' de la couche, située entre la zone fragilisée 19' et la face 18' opposée à celle par laquelle l'implantation précédente a eu lieu.

Il est ensuite procédé (figure 5B) à un assemblage de la couche 18 implantée, par sa face 18" à travers laquelle l'implantation a été réalisée, avec le substrat 2 ferroélectrique.

On obtient la structure de la figure 5B. On fait ensuite subir à cette structure une séparation, induite par effet thermique et/ou mécanique, de la couche mince 23' et de la partie restante 21' de la couche 18, le long de la zone fragilisée 19'. Le résultat de cette étape est représenté en figure 5C, la couche 23' étant assemblée avec le substrat 2.

Il est ensuite procédé à un assemblage de la couche 23', par sa face libre 23'-1, avec le substrat 20 de report : ce sont les étapes décrites ci-dessus en liaison avec les figures 3A et suivantes.

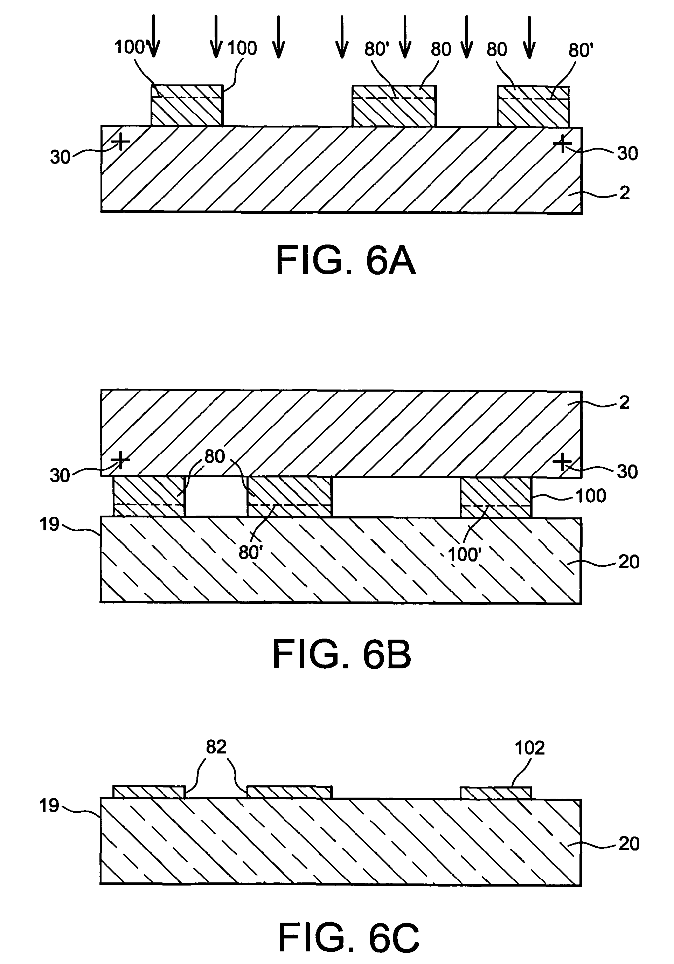

Les figures 6A à 6C illustrent un exemple de mise en oeuvre d'un procédé de transfert de vignettes implantées.

L'assemblage des vignettes avec un substrat 2 ferroélectrique est du type décrit ci-dessus en liaison avec la figure 1A. Les vignettes 80, 100 de la figure 6A sont représentées de manière agrandie par rapport à celles de la figure 1A. L'implantation a lieu après cet assemblage avec le substrat 2 et une zone de fragilisation 80', 100' est ainsi réalisée dans chacune des vignettes 80, 100.

Les étapes correspondantes sont similaires à celles décrites ci-dessus pour les figures 4A - 4E, mais avec des vignettes 80, 100 au lieu d'une couche telle que la couche 18. Ainsi la figure 6B représente l'ensemble obtenu après report des vignettes du substrat 2 sur le substrat 20, mais avant l'étape de séparation.

Après séparation, il en résulte une structure (figure 6C) comportant, sur le substrat 20 de report, une pluralité de couches minces 82, 102, dont chacune résulte de la fracture d'une des vignettes 80, 100 le long du plan 80', 100'.

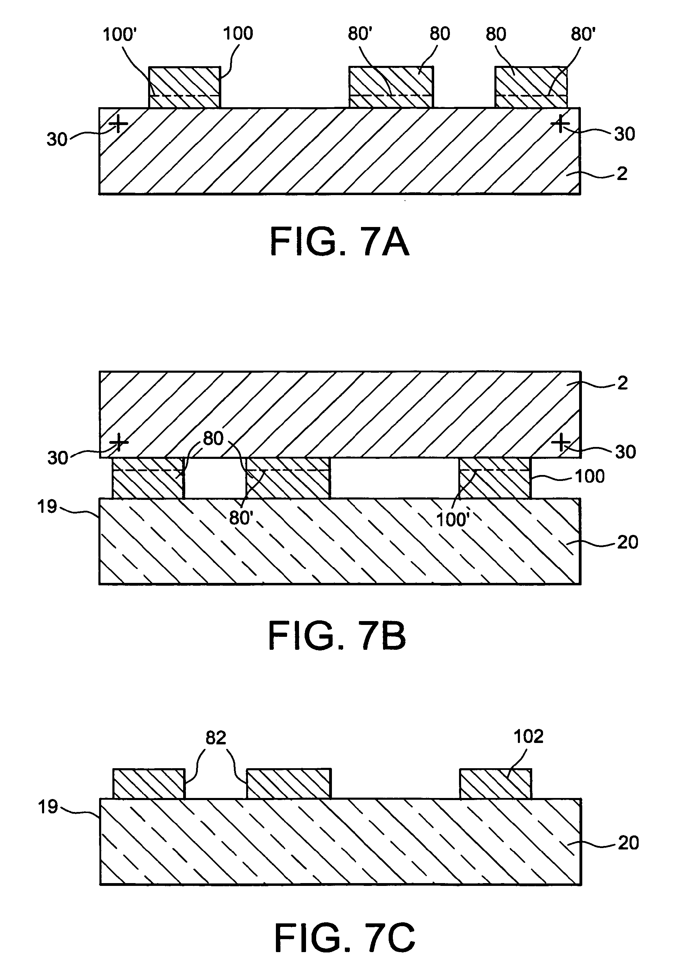

Les figures 7A à 7C illustrent un exemple de mise en oeuvre d'un procédé de transfert de vignettes implantées.

L'implantation a lieu cette fois avant assemblage avec le substrat 2 ferroélectrique (donc avant l'étape représentée en figure 7A). Une zone de fragilisation 80', 100' a ainsi été réalisée dans chacune des vignettes 80, 100, mais cette zone de fragilisation est cette fois proche de la surface de ces vignettes qui est assemblée avec le substrat 2.

Les étapes correspondantes sont similaires à celles décrites ci-dessus pour les figures 5A - 5C, mais avec des vignettes 80, 100 au lieu d'une couche telle que la couche 18. Ainsi la figure 7B représente l'ensemble obtenu après report des vignettes du substrat 2 sur le substrat 20, mais avant l'étape de séparation.

Après séparation, il en résulte une structure (figure 7C) comportant, sur le substrat 20 de report, une pluralité de couches minces 82, 102, dont chacune résulte de la fracture d'une des vignettes 80, 100 le long du plan 80', 100'.

## Revendications

1. Procédé de réalisation d'un transfert d'un ou plusieurs premiers composants (8, 10) ou d'une première couche (18), d'un premier substrat (2) vers un deuxième substrat (20), comportant les étapes suivantes :
a) la mise en contact, contre un premier substrat (2), en un matériau ferroélectrique, du ou des premiers composants ou de la première couche, et leur maintien, par effet électrostatique, contre ce premier substrat électriquement chargé,
b) une mise en contact par adhérence moléculaire, de ces composants ou de cette couche avec le deuxième substrat (20),
c) une séparation ou un démontage du premier substrat, laissant au moins une partie de chacun desdits composants ou de ladite couche sur le deuxième substrat.

2. Procédé selon la revendication 1, l'étape c) de démontage étant assistée thermiquement et/ou mécaniquement et/ou de manière électrostatique.

3. Procédé selon la revendication 2, l'étape c) de démontage étant assistée par une montée en température, par exemple par application d'une rampe thermique croissante, de pente supérieure à 5°C/min.

4. Procédé selon l'une des revendications 1 à 3, l'étape c) de démontage étant assistée par différence entre les forces d'adhérence des premiers composants ou de la première couche sur le premier substrat et sur le deuxième substrat.

5. Procédé selon l'une des revendications 1 à 4, le premier substrat, ferroélectrique, étant chargé de manière intrinsèque ou assistée et/ou étant en LiTaO₃ ou en LiNbO₃, ou en BaTiO₃, ou en SrTiO₃, ou en LaAlO₃, ou en LiAlO₃.

6. Procédé selon l'une des revendications 1 à 5, le deuxième substrat (20) étant au moins partiellement en matériau semi-conducteur, tel que du silicium, ou en silice fondue ou en quartz et/ou au moins un composant ou vignette ou la couche (18) étant au moins partiellement en matériau semi-conducteur.

7. Procédé selon l'une des revendications 1 à 6, un ou plusieurs desdits composants, ou ladite couche, ayant subi avant l'étape a), ou subissant, entre l'étape a) et l'étape b), un traitement par gravure, et/ou implantation ionique, et/ou dépôt et/ou thermique.

8. Procédé selon la revendication 7, un ou plusieurs desdits composants, ou ladite couche :
* ayant subi avant l'étape a), ou subissant, entre l'étape a) et l'étape b), un traitement par implantation ionique, définissant dans au moins un desdits composants ou dans ladite couche, une zone de fragilisation (19, 100', 80, 80'), le long de laquelle une fracture est réalisée lors de l'étape c),
* ou ayant subi, avant l'étape a), un traitement par implantation ionique, définissant dans au moins un desdits composants ou dans ladite couche, une zone de fragilisation (19, 100', 80, 80'), le long de laquelle une fracture est réalisée entre l'étape a) et l'étape b) .

9. Procédé selon l'une des revendications 7 ou 8, ledit traitement thermique n'induisant pas d'inversion de polarisation du matériau du premier substrat, par exemple ledit traitement thermique étant réalisé par application d'une rampe thermique croissante, de pente inférieure à 5°C/min.

10. Procédé selon l'une des revendications 1 à 9, au moins un desdits premiers composants, ou la première couche, et/ou la surface (2') du premier substrat (2) ayant subi au moins une étape de traitement en vue de favoriser le contact ou l'adhésion de ce composant avec cette surface (2') et/ou la surface du deuxième substrat (20) et/ou la surface d'au moins un desdits premiers composants ou de la première couche, ayant subi, avant l'étape b), une préparation en vue du collage moléculaire.

11. Procédé selon l'une des revendications 1 à 10, la surface du premier substrat, en matériau ferroélectrique, comportant une couche d'assistance au collage.

12. Procédé selon l'une des revendications 1 à 11, les surfaces des composants n'étant pas toutes à la même hauteur h par rapport à la surface (2') du deuxième substrat (2) sur laquelle ils sont déposés.

13. Procédé selon l'une des revendications 1 à 12, au moins l'un des composants comportant au moins une surface en un matériau compliant ou élastique.

14. Procédé de réalisation d'un transfert d'au moins deux étages de composants (8, 10, 8', 10') et/ou de couche (18) sur un deuxième substrat (20) comportant les étapes suivantes :
- réalisation d'un transfert d'un premier étage d'un ou plusieurs premiers composants (8, 10) ou d'une première couche (18) sur ledit deuxième substrat (20) selon l'une des revendications 1 à 13, à l'aide d'un premier substrat (2), en un matériau ferroélectrique,
- puis la réalisation d'un transfert d'un deuxième étage d'un ou plusieurs deuxièmes composants (8", 10") ou d'une deuxième couche, sur ledit premier étage.

15. Procédé selon la revendication 14, le transfert d'un deuxième étage étant réalisé par :
a') l'application et le maintien, par effet électrostatique, desdits un ou plusieurs deuxièmes composants (8" , 10" ) ou de ladite deuxième couche, sur ledit premier étage, à l'aide d'un substrat (2), en un matériau ferroélectrique, électriquement chargé,
b') une mise en contact et un report de ces composants ou de cette couche sur ledit premier étage,
c')un démontage dudit substrat en un matériau ferroélectrique, laissant le ou les composants (8" , 10" ) ou ladite deuxième couche sur le premier étage.

## Claims

1. Method of carrying out a transfer of one or more first components (8, 10) or of a first layer (18), from a first substrate (2) to a second substrate (20), comprising the following steps:
a) a placing in contact, against a first substrate (2), made of a ferroelectric material, of the first component(s) or the first layer, and maintaining them, by electrostatic effect, against this first electrically charged substrate,
b) a placing in contact, direct or by molecular adhesion, of these components or of this layer with the second substrate (20),
c) a separation or a dismantling of the first substrate, leaving at least one part of each of said components or said layer on the second substrate.

2. Method according to claim 1, the step c) of dismantling being assisted thermally and/or mechanically and/or in an electrostatic manner.

3. Method according to claim 2, the dismantling step c) being assisted by a rise in temperature, for example by application of an increasing thermal ramp, of gradient greater than 5°C/min.

4. Method according to one of claims 1 to 3, the dismantling step c) being assisted by difference between the adhesion forces of the first components or of the first layer on the first substrate and on the second substrate.

5. Method according to one of claims 1 to 4, the first substrate, ferroelectric, being charged in an intrinsic or assisted manner and /or being made of LiTaO₃ or LiNbO₃, or BaTiO₃, or SrTiO₃, or LaAlO₃, or LiAlO₃ .

6. Method according to one of claims 1 to 5, the second substrate (20) being at least partially made of semi-conductor material, such as silicon, or fused silica or quartz and/or at least one component or stamp or the layer (18) being at least partially made of semi-conductor material.

7. Method according to one of claims 1 to 6, one or more of said components, or said layer, having undergone before step a), or undergoing, between step a) and step b), a treatment by etching, and/or ion implantation, and/or deposition and/or thermal.

8. Method according to claim 7, one or more of said components, or said layer:
- having undergone before step a), or undergoing, between step a) and step b), a treatment by ion implantation, defining in at least one of said components or in said layer, a fragilization area (19, 100', 80, 80'), along which a fracture is formed during step c);
- or having undergone, before step a), a treatment by ion implantation, defining in at least one of said components or in said layer, a fragilization area (19, 100', 80, 80'), along which a fracture is formed between step a) and step b).

9. Method according to one of claims 7 or 8, said thermal treatment not inducing polarisation inversion of the material of the first substrate, for example said thermal treatment being carried out by application of an increasing thermal ramp, of gradient less than 5°C/min.

10. Method according to one of claims 1 to 9, at least one of said first components, or the first layer, and/or the surface (2') of the first substrate (2) having undergone at least one step of treatment for the purpose of promoting the contact or the adhesion of this component with this surface (2') and/or the surface of the second substrate (20) and/or the surface of at least one of said first components or of the first layer, having undergone, before step b), a preparation for the purpose of the molecular bonding.

11. Method according to one of claims 1 to 10, the surface of the first substrate, made of ferroelectric material, comprising a bonding assistance layer.

12. Method according to one of claims 1 to 11, the surfaces of the components not being all at the same height h in relation to the surface (2') of the second substrate (2) on which they are deposited.

13. Method according to one of claims 1 to 12, at least one of the components comprising at least one surface made of a compliant or elastic material.

14. Method of carrying out a transfer of at least two stages of components (8, 10, 8', 10') and/or of layer (18) onto a second substrate (20) comprising the following steps:
- carrying out a transfer of a first stage of one or more first components (8, 10) or of a first layer (18) onto said second substrate (20) according to one of claims 1 to 13, by means of a first substrate (2), made of a ferroelectric material,
- then carrying out a transfer of a second stage of one or more second components (8" , 10") or a second layer, onto said first stage.

15. Method according to claim 14, the transfer of a second stage being carried out by:
a') the application and the maintaining, by electrostatic effect, of said one or more second components (8" , 10") or of said second layer, on said first stage, by means of a substrate (2), made of a ferroelectric material, electrically charged,
b') a placing in contact and a transfer of these components or this layer onto said first stage,
c') a dismantling of said substrate made of a ferroelectric material, leaving the component(s) (8", 10") or said second layer on the first stage.

## Patentansprüche

1. Verfahren zum Übertragen einer oder mehrerer erster Komponenten (8,10) oder einer ersten Schicht (18) von einem ersten Substrat (2) auf ein zweites Substrat (20) mit den folgenden Schritten:
a) Herstellen eines Kontakts der ersten Komponente(n) oder der ersten Schicht mit einem ersten Substrat (2) aus einem ferroelektrischen Material und ihr Halten an diesem elektrisch geladenen ersten Substrat durch elektrostatische Wirkung,
b) Herstellen eines Kontakts dieser Komponenten oder dieser Schicht mit dem zweiten Substrat (20) durch molekulare Adhäsion,
c) Trennen oder Abnehmen des ersten Substrats, wobei mindestens ein Teil jeder Komponente oder der Schicht an dem zweiten Substrat bleibt.

2. Verfahren nach Anspruch 1, wobei der Abnahmeschritt c) thermisch und/oder mechanisch und/oder elektrostatisch unterstützt wird.

3. Verfahren nach Anspruch 2, wobei der Abnahmeschritt c) durch eine Temperaturerhöhung unterstützt wird, zum Beispiel durch Anwenden eines Temperaturanstiegs mit einer Steigung von mehr als 5°C/min.

4. Verfahren nach einem der Ansprüche 1 bis 3, wobei der Abnahmeschritt c) unterstützt wird durch einen Unterschied zwischen den Adhäsionskräften der ersten Komponenten oder der ersten Schicht an dem ersten Substrat und an dem zweiten Substrat.

5. Verfahren nach einem der Ansprüche 1 bis 4, wobei das erste ferroelektrische Substrat auf intrinsische oder unterstützte Weise geladen ist und/oder aus LiTaO₃ oder aus LiNbO₃ oder aus BaTiO₃ oder aus SrTiO₃ oder aus LaAlO₃ oder aus LiAlO₃ besteht.

6. Verfahren nach einem der Ansprüche 1 bis 5, wobei das zweite Substrat (20) zumindest teilweise aus einem Halbleitermaterial, beispielsweise Silizium, oder aus Quarzglas oder aus Quarz besteht und/oder mindestens eine Komponente oder die Schicht (18) zumindest teilweise aus einem Halbleitermaterial besteht.

7. Verfahren nach einem der Ansprüche 1 bis 6, wobei eine oder mehrere der Komponenten oder die Schicht einer Ätzbehandlung und/oder Ionenimplantation und/oder Beschichtung und/oder thermischen Behandlung vor dem Schritt a) unterzogen worden sind oder zwischen dem Schritt a) und dem Schritt b) unterzogen werden.

8. Verfahren nach Anspruch 7, wobei eine oder mehrere der Komponenten oder die Schicht
* einer Behandlung mittels Ionenimplantation vor dem Schritt a) unterzogen worden sind oder zwischen dem Schritt a) und b) unterzogen werden, die in mindestens einer der Komponenten oder in der Schicht eine Sprödigkeitszone (19,100' ,80,80') festlegt, entlang derer während des Schritts c) ein Bruch erfolgt,
* einer Behandlung mittels Ionenimplantation vor dem Schritt a) unterzogen worden sind, die in mindestens einer der Komponenten oder in der Schicht eine Sprödigkeitszone (19,100' ,80,80') festlegt, entlang derer zwischen dem Schritt a) und b) ein Bruch erfolgt.

9. Verfahren nach einem der Ansprüche 7 oder 8, wobei die thermische Behandlung keine Polarisationsumkehr des Materials des ersten Substrats hervorruft, wobei die thermische Behandlung zum Beispiel durch Anwenden eines Temperaturanstiegs mit einer Steigung von weniger als 5°C/min erfolgt.

10. Verfahren nach einem der Ansprüche 1 bis 9, wobei mindestens eine der ersten Komponenten oder die erste Schicht und/oder die Oberfläche (2') des ersten Substrats (2) mindestens einem Behandlungsschritt unterzogen worden sind, um den Kontakt oder die Adhäsion dieser Komponente mit dieser Oberfläche (2') zu begünstigen, und/oder die Oberfläche des zweiten Substrats (20) und/oder die Oberfläche mindestens einer der ersten Komponenten oder der ersten Schicht vor dem Schritt b) einer Vorbehandlung in Hinblick auf das molekulare Kleben unterzogen worden sind.

11. Verfahren nach einem der Ansprüche 1 bis 10, wobei die Oberfläche des ersten Substrats aus ferroelektrischem Material eine Klebehilfsschicht aufweist.

12. Verfahren nach einem der Ansprüche 1 bis 11, wobei die Oberflächen der Komponenten nicht alle die gleiche Höhe h bezüglich der Oberfläche (2') des ersten Substrats (2) haben, an welchem sie angeordnet sind.

13. Verfahren nach einem der Ansprüche 1 bis 12, wobei mindestens eine der Komponenten mindestens eine Oberfläche aus einem nachgiebigen oder elastischen Material aufweist.

14. Verfahren zum Übertragen von mindestens zwei aus Komponenten (8,10,8' ,10') und/oder aus einer Schicht (18) bestehenden Stockwerken auf ein zweites Substrat (20) mit den folgenden Schritten:
- Übertragen eines aus einer oder mehreren ersten Komponenten (8,10) oder aus einer ersten Schicht (18) bestehenden ersten Stockwerks auf das zweite Substrat (20) nach einem der Ansprüche 1 bis 13 mit Hilfe eines ersten Substrats (2) aus einem ferroelektrischen Material,
- anschließendes Übertragen eines aus einer oder mehreren zweiten Komponenten (8" ,10") oder aus einer zweiten Schicht bestehenden zweiten Stockwerks auf das erste Stockwerk.

15. Verfahren nach Anspruch 14, wobei das Übertragen eines zweiten Stockwerks erfolgt durch:
a') Anordnen und elektrostatisches Halten der einen oder mehreren zweiten Komponenten (8" ,10") oder der zweiten Schicht auf dem ersten Stockwerk mit Hilfe eines elektrisch geladenen Substrats aus einem ferroelektrischen Material,
b') Herstellen eines Kontakts und Transferieren dieser Komponenten oder dieser Schicht auf das erste Stockwerk,
c') Abnehmen des Substrats aus einem ferroelektrischen Material, wobei die Komponente(n) (8" ,10") oder die zweite Schicht auf dem ersten Stockwerk bleiben.
